# EUROPEAN PATENT APPLICATION

(11) **EP 4 597 299 A1**
(43) Date of publication of application: **06.08.2025**
(21) Application number: 23878671.9
(22) Date of filing: 25.06.2023
(51) Int. Cl.: G06F 7/483

(54) **FLOATING-POINT DATA PRECISION CONVERSION METHOD AND APPARATUS**

(30) Priority: 19.10.2022 CN 202211281416
(71) Applicant: Huawei Technologies Co., Ltd., Shenzhen, Guangdong 518129 (CN)
(72) Inventor: LUO, Yuanyong, Shenzhen, Guangdong 518129 (CN); CHEN, Minqi, Shenzhen, Guangdong 518129 (CN); ZHANG, Zhongxing, Shenzhen, Guangdong 518129 (CN); WU, Wei Hsiang, Shenzhen, Guangdong 518129 (CN)
(74) Representative: Gill Jennings & Every LLP
(86) International application number: PCT/CN2023/102089
(87) International publication number: WO 2024/082674

(57) **Abstract**

Embodiments of this application relate to the field of chip technologies and provide a floating-point data precision conversion method and apparatus, to improve overall mean invariance during conversion from high-precision data to low-precision data. A specific solution is as follows: determining a first bit width of a prefix code field, a first coded value of the prefix code field, a first bit width of a second exponent field, a first coded value of the second exponent field, and a first bit width of a second mantissa field based on a first coded value of a first exponent field; determining a to-be-retained coded value and a to-be-discarded coded value in a first mantissa field, where the to-be-retained coded value includes a coded value that starts from a most significant bit in the first mantissa field and whose bit width is the same as the first bit width of the second mantissa field; and performing a rounding operation on the to-be-retained coded value based on the to-be-discarded coded value, to obtain a first coded value of the second mantissa field. Embodiments of this application are used in a process of converting high-precision data into low-precision data.

## Description

This application claims priority to Chinese Patent Application No. 202211281416.6, filed with the China National Intellectual Property Administration on October 19, 2022 and entitled "FLOATING-POINT DATA PRECISION CONVERSION METHOD AND APPARATUS", which is incorporated herein by reference in its entirety.

### TECHNICAL FIELD

This application relates to the field of chip technologies, and in particular, to a floating-point data precision conversion method and apparatus.

### BACKGROUND

With rapid development of mixed-precision computing, computing resources in a low-precision floating-point data format begin to be deployed on a large scale. For example, a floating point (Floating Point, FP) 16 and FP32 mixed training mode and a brain floating point (Brain Floating Point, BF) 16 and FP32 mixed training mode are deployed in the artificial intelligence (Artificial Intelligence, AI) field, and FP32 and FP64 mixed precision is deployed in the high-performance computing (High-Performance Computing, HPC) service field. Currently, a plurality of 8-bit floating-point data formats, such as shared exponent bias (Shard Exponent Bias, SEB), hybrid FP8 (Hybrid FP8, HFP8), and configurable FP8 (Configurable FP8, CFP8), are proposed in the academic world and the industry. To deploy large-scale low-precision computing power in the HPC service field that requires high precision, a plurality of mixed-precision solver algorithms are proposed. In these algorithms, a low-precision initial computing result is first obtained through computing by using low-precision computing power such as FP16 or BF 16, and then a high-precision computing result is obtained through computing by using an iterative algorithm and a high-precision data format FP32 or FP64. In a mixed-precision computing scenario, conversion needs to be performed between data with different precision. During format conversion from low-precision data to high-precision data, conversion can be implemented without an error. During format conversion from high-precision data to low-precision data, a rounding (rounding) operation needs to be performed on the high-precision data. Therefore, a conversion error occurs, and overall mean invariance during the conversion from the high-precision data to the low-precision data is reduced. Different rounding modes correspond to different conversion errors. Especially in an AI training scenario, a rounding operation on high-precision data causes error accumulation effect. This affects training precision of an AI model.

### SUMMARY

Embodiments of this application provide a floating-point data precision conversion method and apparatus, to implement conversion from high-precision data to low-precision data. A prefix code field in second floating-point data indicates a bit width of a second exponent field. This effectively balances a relationship between a bit width, a range, and precision of the second floating-point data. In addition, a simple rounding mode is provided. A rounding operation is performed on a to-be-retained coded value based on a to-be-discarded coded value in a first mantissa field, without support from another device. This improves conversion efficiency of conversion from high-precision data to low-precision data, and reduces hardware overheads.

To achieve the foregoing objectives, the following technical solutions are used in embodiments of this application.

According to a first aspect, an embodiment of this application provides a floating-point data precision conversion method. First floating-point data includes a sign field, a first exponent field, and a first mantissa field. Second floating-point data includes a sign field, a prefix code field, a second exponent field, and a second mantissa field. The prefix code field indicates a bit width of the second exponent field. Precision of the first floating-point data is higher than precision of the second floating-point data. The method includes: determining a first bit width of the prefix code field, a first coded value of the prefix code field, a first bit width of the second exponent field, a first coded value of the second exponent field, and a first bit width of the second mantissa field based on a first coded value of the first exponent field; determining a to-be-retained coded value and a to-be-discarded coded value in the first mantissa field, where the to-be-retained coded value includes a coded value that starts from a most significant bit in the first mantissa field and whose bit width is the same as the first bit width of the second mantissa field; and performing a rounding operation on the to-be-retained coded value based on the to-be-discarded coded value, to obtain a first coded value of the second mantissa field.

In the floating-point data precision conversion method provided in this embodiment of this application, conversion from high-precision data to low-precision data is implemented. During data format conversion, the sign field of the second floating-point data may be obtained based on the sign field of the first floating-point data, the prefix code field and the second exponent field of the second floating-point data may be obtained based on the first exponent field of the first floating-point data, and the second mantissa field of the second floating-point data may be obtained based on the first mantissa field of the first floating-point data. In the second floating-point data, the bit width of the second exponent field is indicated by the short prefix code field, so that precision or a bit width of a mantissa of the second floating-point data can be effectively improved. In addition, the second floating-point data that provides precision with only a one-digit mantissa may represent a large value range, so that a relationship between a bit width, a range, and precision of the second floating-point data is effectively balanced. In addition, the prefix code field may be encoded by using a prefix code and occupies a small bit width, and it is convenient to parse the second exponent field and the second mantissa field. In addition, a simple rounding mode is provided. The rounding operation is performed on the to-be-retained coded value based on the to-be-discarded coded value in the first mantissa field, without support from another device. This improves conversion efficiency of conversion from high-precision data to low-precision data, and reduces hardware overheads.

In a possible design, the rounding operation includes a carry operation and a discard operation, and the performing a rounding operation on the to-be-retained coded value based on the to-be-discarded coded value, to obtain a first coded value of the second mantissa field includes: when a coded value that starts from a most significant bit in the to-be-discarded coded value and whose bit width is a preset bit width is greater than or equal to a second preset threshold, performing a carry operation on a least significant bit of the to-be-retained coded value, and performing a discard operation on the to-be-discarded coded value, where a coded value obtained through the carry operation on the to-be-retained coded value is the first coded value of the second mantissa field; or when a coded value that starts from a most significant bit in the to-be-discarded coded value and whose bit width is a preset bit width is less than a second preset threshold, performing a discard operation on the to-be-discarded coded value, where the to-be-retained coded value is the first coded value of the second mantissa field, and the second preset threshold is a coded value that starts from a least significant bit in the to-be-discarded coded value and whose bit width is a preset bit width.

In this design, in a stochastic rounding mode, the second preset threshold used for comparison is a coded value that starts from the least significant bit in the to-be-discarded coded value and whose bit width is the preset bit width. The second preset threshold is generated without an additional random number generator, and random number generation has no performance bottleneck, so that efficiency of conversion from high-precision data to low-precision data is improved, and hardware overheads are lower.

In a possible design, the rounding operation includes a carry operation or a discard operation, and the performing a rounding operation on the to-be-retained coded value based on the to-be-discarded coded value, to obtain a first coded value of the second mantissa field includes: when a most significant bit of the to-be-discarded coded value is greater than or equal to a first preset threshold, performing a carry operation on a least significant bit of the to-be-retained coded value, and performing a discard operation on the to-be-discarded coded value, where a coded value obtained through the carry operation on the to-be-retained coded value is the first coded value of the second mantissa field; or when a most significant bit of the to-be-discarded coded value is less than a first preset threshold, performing a discard operation on the to-be-discarded coded value, where the to-be-retained coded value is the first coded value of the second mantissa field.

In this design, the first preset threshold may be 0 or 1, and the most significant bit of the to-be-discarded coded value is compared with the first preset threshold. This is a rounding mode of rounding half to away. In addition to the rounding mode of rounding half to away, a rounding mode of rounding half to even, a rounding mode of rounding half to odd, and the like may be further included. However, compared with other rounding modes, the rounding mode of rounding half to away has a smaller hardware implementation area, lower power consumption overheads, and a higher data resolution.

In a possible design, the floating-point data precision conversion method provided in this embodiment of this application further includes: determining whether the to-be-retained coded value obtained through the carry operation overflows; if the to-be-retained coded value obtained through the carry operation overflows, performing a plus-1 operation on a least significant bit of the first coded value of the first exponent field to obtain a second coded value of the first exponent field; if the second bit width of the prefix code field is different from the first bit width of the prefix code field, determining a second coded value of the prefix code field, a second coded value of the second exponent field, a second bit width of the second mantissa field, and a second coded value of the second mantissa field based on the second coded value of the first exponent field; or if the second bit width of the prefix code field is the same as the first bit width of the prefix code field, determining whether the first bit width of the second exponent field is the same as the second bit width of the second exponent field; and if the second bit width of the second exponent field is less than the first bit width of the second exponent field, performing a plus-1 operation on a bit width of the to-be-retained coded value to obtain a second bit width of the second mantissa field and a second coded value of the second mantissa field; or if the second bit width of the second exponent field is greater than or equal to the first bit width of the second exponent field, performing a discard operation on the least significant bit of the to-be-retained coded value to obtain a second bit width of the second mantissa field and a second coded value of the second mantissa field.

In this design, when overflow occurs, the second bit width of the prefix code field and the bit width of the second exponent field are obtained through the plus-1 operation on the least significant bit of the first coded value of the first exponent field. When the second bit width of the prefix code field is the same as the first bit width of the prefix code field, the second bit width of the second mantissa field may be obtained if the bit width of the second exponent field changes. This can resolve the problem that overflow occurs after the carry operation is performed on the to-be-retained coded value.

In a possible design, the determining a first bit width of the prefix code field, a first coded value of the prefix code field, a first bit width of the second exponent field, and a first coded value of the second exponent field based on a first coded value of the first exponent field includes: determining an indication value based on the first coded value of the first exponent field, and determining, through table lookup, the first bit width of the prefix code field and the first coded value of the prefix code field that correspond to the indication value, where the indication value further indicates the first bit width of the second exponent field; and determining, based on the first coded value of the first exponent field, the first coded value corresponding to the first bit width of the second exponent field.

In a possible design, the determining a first bit width of the second mantissa field based on a first coded value of the first exponent field includes: determining the first bit width of the second mantissa field based on a total bit width of the second floating-point data, the first bit width of the prefix code field, and the first bit width of the second exponent field.

In this design, for example, for the second floating-point data in a HiFloat8 data format, a bit width of the sign field is 1, a bit width of the prefix code field is 2 or 3, the first bit width of the second exponent field is an integer ranging from 0 to 4, and the first bit width of the second mantissa field is an integer ranging from 1 to 4. Therefore, in the second floating-point data, the first bit width of the second exponent field is indicated by the short prefix code field, so that the second floating-point data can provide maximum precision with a four-digit mantissa. In addition, the second floating-point data that provides precision with only a one-digit mantissa may represent a large value range, so that a relationship between a bit width, a range, and precision of the second floating-point data is effectively balanced. In addition, a most significant bit is hidden when the second exponent field is stored, so that the first bit width, which needs to be stored, of the second exponent field is reduced. This effectively avoids a problem that values of first coded values of second exponent fields corresponding to indication values of different prefix code fields overlap, so that the HiFloat8 data format does not include redundant codes.

In a possible design, when the first floating-point data exceeds an upper limit of a data range of the second floating-point data, the second floating-point data is determined in a saturation mode or an infinity mode; when the first floating-point data exceeds a lower limit of a data range of the second floating-point data, the second floating-point data is zero; or when the first floating-point data is not a number, the second floating-point data is not a number.

In this design, when the first floating-point data exceeds the upper limit and the lower limit of the data range of the second floating-point data, the second floating-point data may represent the first floating-point data by using special values, for example, a saturation value, an infinite value, and a zero value. When the first floating-point data is not a number, the second floating-point data is not represented by a number either.

According to a second aspect, an embodiment of this application provides a floating-point data precision conversion apparatus. First floating-point data includes a sign field, a first exponent field, and a first mantissa field. Second floating-point data includes a sign field, a prefix code field, a second exponent field, and a second mantissa field. The prefix code field indicates a bit width of the second exponent field. Precision of the first floating-point data is higher than precision of the second floating-point data. The apparatus includes: a bit width computing unit, configured to determine a first bit width of the prefix code field, a first coded value of the prefix code field, a first bit width of the second exponent field, a first coded value of the second exponent field, and a first bit width of the second mantissa field based on a first coded value of the first exponent field; a mantissa field computing unit, configured to determine a to-be-retained coded value and a to-be-discarded coded value in the first mantissa field, where the to-be-retained coded value includes a coded value that starts from a most significant bit in the first mantissa field and whose bit width is the same as the first bit width of the second mantissa field; and a rounding operation unit, configured to perform a rounding operation on the to-be-retained coded value based on the to-be-discarded coded value, to obtain a first coded value of the second mantissa field.

For benefits of the second aspect, refer to the descriptions of the first aspect.

In a possible design, the rounding operation includes a carry operation or a discard operation, and the rounding operation unit is further configured to: when a coded value that starts from a most significant bit in the to-be-discarded coded value and whose bit width is a preset bit width is greater than or equal to a second preset threshold, perform a carry operation on a least significant bit of the to-be-retained coded value, and perform a discard operation on the to-be-discarded coded value, where a coded value obtained through the carry operation on the to-be-retained coded value is the first coded value of the second mantissa field; or when a coded value that starts from a most significant bit in the to-be-discarded coded value and whose bit width is a preset bit width is less than a second preset threshold, perform a discard operation on the to-be-discarded coded value, where the to-be-retained coded value is the first coded value of the second mantissa field, and the second preset threshold is a coded value that starts from a least significant bit in the to-be-discarded coded value and whose bit width is a preset bit width.

In a possible design, the rounding operation includes a carry operation or a discard operation, and the rounding operation unit is further configured to: when a most significant bit of the to-be-discarded coded value is greater than or equal to a first preset threshold, perform a carry operation on a least significant bit of the to-be-retained coded value, and perform a discard operation on the to-be-discarded coded value, where a coded value obtained through the carry operation on the to-be-retained coded value is the first coded value of the second mantissa field; or when a most significant bit of the to-be-discarded coded value is less than a first preset threshold, perform a discard operation on the to-be-discarded coded value, where the to-be-retained coded value is the first coded value of the second mantissa field.

In a possible design, the apparatus further includes an overflow unit, configured to determine whether the to-be-retained coded value obtained through the carry operation overflows. The bit width computing unit is further configured to: if the to-be-retained coded value obtained through the carry operation overflows, perform a plus-1 operation on the first coded value of the first exponent field to obtain a second coded value of the first exponent field; determine a second bit width of the second exponent field and a second bit width of the prefix code field based on the second coded value of the first exponent field; and if the second bit width of the prefix code field is different from the first bit width of the prefix code field, determine a second coded value of the prefix code field, a second coded value of the second exponent field, a second bit width of the second mantissa field, and a second coded value of the second mantissa field based on the second coded value of the first exponent field; or if the second bit width of the prefix code field is the same as the first bit width of the prefix code field, determine whether the first bit width of the second exponent field is the same as the second bit width of the second exponent field; and if the second bit width of the second exponent field is less than the first bit width of the second exponent field, perform a plus-1 operation on a bit width of the to-be-retained coded value to obtain a second bit width of the second mantissa field and a second coded value of the second mantissa field; or if the second bit width of the second exponent field is greater than or equal to the first bit width of the second exponent field, perform a discard operation on the least significant bit of the to-be-retained coded value to obtain a second bit width of the second mantissa field and a second coded value of the second mantissa field.

In a possible design, the bit width computing unit is further configured to: determine an indication value based on the first coded value of the first exponent field, and determine, through table lookup, the first bit width of the prefix code field and the first coded value of the prefix code field that correspond to the indication value, where the indication value further indicates the first bit width of the second exponent field; and determine, based on the first coded value of the first exponent field, the first coded value corresponding to the first bit width of the second exponent field.

In a possible design, the bit width computing unit is further configured to determine the first bit width of the second mantissa field based on a total bit width of the second floating-point data, the first bit width of the prefix code field, and the first bit width of the second exponent field.

In a possible design, the bit width computing unit is further configured to: when the first floating-point data exceeds an upper limit of a conversion range of the second floating-point data, determine the second floating-point data in a saturation mode or an infinity mode; when the first floating-point data exceeds a lower limit of a conversion range of the second floating-point data, the second floating-point data is zero; or when the first floating-point data is not a number, the second floating-point data is not a number.

According to a third aspect, a communication apparatus is provided, including at least one processor. The at least one processor is connected to a memory. The at least one processor is configured to read and execute a program stored in the memory, to enable the apparatus to perform the method according to any one of the first aspect or the implementations of the first aspect.

According to a fourth aspect, a chip is provided. The chip is coupled to a memory, and is configured to read and execute program instructions stored in the memory, to implement the method according to any one of the first aspect or the implementations of the first aspect.

According to a fifth aspect, this application provides a chip system. The chip system is used in a cloud center. The chip system includes one or more interface circuits and one or more processors. The interface circuit and the processor are interconnected through a line. The interface circuit is configured to receive a signal from a memory of the cloud center, and send the signal to the processor. The signal includes computer instructions stored in the memory. When the processor executes the computer instructions, the cloud center performs the floating-point data precision conversion method provided in the first aspect or a corresponding possible design of the first aspect.

According to a sixth aspect, an embodiment of this application provides a computer-readable storage medium, including computer instructions. When the computer instructions are run on an electronic device, the electronic device is enabled to perform the floating-point data precision conversion method according to any one of the foregoing aspects or the possible implementations.

According to a seventh aspect, an embodiment of this application provides a computer program product. When the computer program product is run on a computer or a processor, the computer or the processor is enabled to perform the floating-point data precision conversion method according to any one of the foregoing aspects or the possible implementations.

It can be understood that a corresponding method provided above may be used for any one of the floating-point data precision conversion apparatus, the chip system, the computer-readable storage medium, the computer program product, or the like provided above. Therefore, for benefits that can be achieved, refer to benefits of the corresponding method. Details are not described herein again.

These aspects or other aspects in this application are more concise and comprehensible in the following descriptions.

### BRIEF DESCRIPTION OF DRAWINGS

FIG. 1 is a diagram of an IEEE 754 floating-point data format according to an embodiment of this application;
FIG. 2 is a diagram of a system or a device in which a floating-point data precision conversion method or apparatus is used according to an embodiment of this application;
FIG. 3 is a diagram of a structure of an SoC according to an embodiment of this application;
FIG. 4 is a flowchart of a floating-point data precision conversion method according to an embodiment of this application;
FIG. 5 is a diagram of a structure of a stochastic rounding mode according to an embodiment of this application;
FIG. 6 is a flowchart of a rounding mode of rounding half to away according to an embodiment of this application;
FIG. 7 is a flowchart of another floating-point data precision conversion method according to an embodiment of this application;
FIG. 8 is a flowchart of another floating-point data precision conversion method according to an embodiment of this application;
FIG. 9A and FIG. 9B are a flowchart of converting FP32 data into HiFloat8 data according to an embodiment of this application; and
FIG. 10 is a diagram of a structure of an electronic device according to an embodiment of this application.

### DESCRIPTION OF EMBODIMENTS

For ease of understanding, some concepts related to embodiments of this application are described as examples for reference. Details are as follows:
A scalar computing unit: A circuit for scalar computing is referred to as a scalar computing unit. A scalar is also referred to as a scalar quantity, which has only a magnitude but no direction. Scalar computing is mainly used for general-purpose computing. In an execution unit (Execution Unit, EXU) part of a multi-stage pipeline of a central processing unit (Central Processing Unit, CPU) and a scalar computing part of another processor with a similar function, an arithmetic logic unit (Arithmetic Logic Unit, ALU) based on a HiFloat data format may be embedded.

A vector computing unit: a computing unit that is specially designed for vector computing and that has a specific degree of parallelism, for example, a single instruction multiple data (Single Instruction Multiple Data, SIMD) processor. A vector is also referred to as a vector quantity, which is generally a one-dimensional array with a length greater than 1. The vector computing unit is mainly used in the fields of HPC, AI machine learning, and the like, including linear programming, Fourier transform, filter computing, and solving of mathematical problems such as linear algebra, partial differential equations, and integrals. In a vector computing acceleration unit or a vector processor, an arithmetic execution unit (Vector Unit) based on a HiFloat data format may be embedded.

A matrix computing unit: a computing unit that is specially designed for matrix computing and that has a corresponding degree of parallelism, for example, a systolic array (systolic array) processor. A matrix is a two-dimensional array arranged in a rectangular array. The matrix computing unit is mainly used for matrix computing in the fields of HPC, AI machine learning, and the like, including matrix multiplication, matrix inversion, matrix decomposition, and the like. In a matrix computing acceleration unit, a matrix unit (Matrix Unit) based on a HiFloat data format may be embedded.

A tensor computing unit: A computing unit that is specially designed for tensor computing and that has a corresponding degree of parallelism is referred to as a tensor computing unit, for example, a cube (Cube) computing unit. A tensor is a multi-dimensional array with more than two dimensions, and is commonly a three-dimensional array. The tensor computing unit is mainly used in the field of AI machine learning, for example, a convolution operation. In a tensor computing acceleration unit, a tensor unit (Tensor Unit) based on a HiFloat data format may be embedded.

The following describes technical solutions in embodiments of this application with reference to accompanying drawings in embodiments of this application. In descriptions of embodiments of this application, "/" indicates "or", unless otherwise specified. For example, A/B may indicate A or B. In this specification, "and/or" describes only an association relationship between associated objects, and indicates that three relationships may exist. For example, A and/or B may indicate the following three cases: Only A exists, both A and B exist, and only B exists. In addition, in descriptions of embodiments of this application, "a plurality of" means two or more.

The terms "first" and "second" used below are merely intended for a purpose of description, and shall not be understood as an indication or an implication of relative importance or an implicit indication of a quantity of indicated technical features. Therefore, a feature limited by "first" or "second" may explicitly or implicitly include one or more features. In descriptions of embodiments, "a plurality of" means two or more, unless otherwise specified.

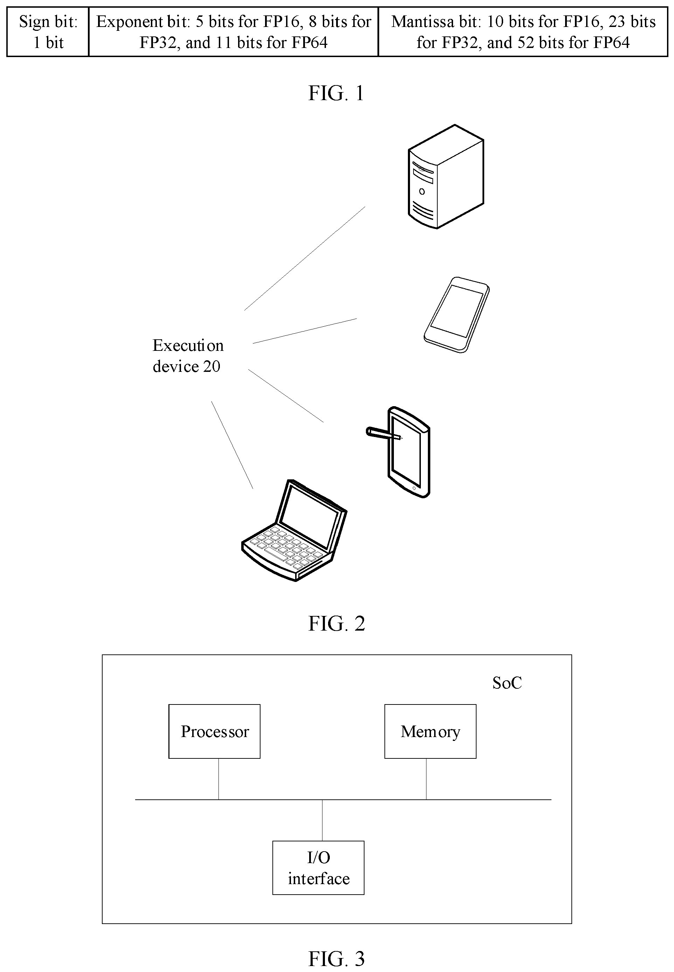

The Institute of Electrical and Electronics Engineers (Institute of Electrical and Electronics Engineers, IEEE) defines IEEE 754 as a binary floating-point arithmetic standard, which defines floating-point data representation methods such as double-precision FP64, single-precision FP32, and half-precision FP 16. Double-precision FP64 data and single-precision FP32 data are applicable to a CPU and a floating-point arithmetic unit environment. Half-precision FP16 data is applicable to a computer graphics environment. FIG. 1 is a diagram of an IEEE 754 floating-point data format according to an embodiment of this application. IEEE 754 floating-point data includes a sign field (bit sign, S), an exponent field (bits exponent, E), and a mantissa field (bits mantissa, M). For FP64 data, a sign field includes 1 bit, an exponent field includes 11 bits, and a mantissa field includes 52 bits. For FP32 data, a sign field includes 1 bit, an exponent field includes 8 bits, and a mantissa field includes 23 bits. For FP16 data, a sign field includes 1 bit, an exponent field includes 5 bits, and a mantissa field includes 10 bits. A formula for conversion between floating-point data represented by using IEEE 754 and a decimal value (Value) is as follows: Value=(-1)^{sign}*2^{exponent-bias}*(1+mantissa), where bias indicates different constants for floating-point data of FP64, FP32, FP16, and the like.

First floating-point data provided in embodiments of this application is FP32 data. The following first describes a data format of the FP32 data. For example, Table 1 shows the data format of the FP32 data.

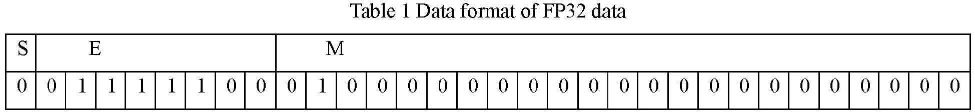

The FP32 data includes a sign field S, an exponent field E, and a mantissa field M. The sign field of the FP32 data determines whether the FP32 data is a positive number or a negative number, where 0 indicates a positive number, and 1 indicates a negative number. The exponent field of the FP32 data is a power of 2, and the FP32 data may be weighted. The mantissa field of the FP32 data is a binary decimal. Steps of converting the FP32 data into decimal data are as follows: (1) If the sign field of the FP32 data is 0, the FP32 data is a positive number. (2) A coded value of the exponent field of the FP32 data is 01111100, which indicates 124 in decimal. A bias (bias) in the FP32 data is removed (for the FP32 data, the bias is 127). In this case, the exponent field of the FP32 data is 2 to the power of -3. (3) The mantissa field of the FP32 data is 01000000000000000000000. Because the exponent field is not all "0s" or all "1s", decimal data represented by the mantissa field is 1.25. Therefore, based on the formula for conversion between floating-point data and a decimal value, decimal data corresponding to the FP32 data is 0.15625.

In an AI mixed training mode and the HPC service field, an existing data format, for example, FP32 data, has a large bit width, leading to high data storage and transfer overheads. In addition, an increasing quantity of applications do not need high-precision data formats such as FP64 data. Therefore, high-precision data needs to be converted into low-precision data. During conversion, a rounding operation needs to be performed on the high-precision data, and therefore a conversion error occurs.

The conventional technology provides a simplified stochastic rounding mode for conversion from an FP32 data format to an FP16 or BF16 data format, where a threshold for stochastic rounding is calculated by using specific bits of the data. In this mode, bits 11 to 18 and bits 16 to 23 in a mantissa field (23 bits in total, numbered 1 to 23 from a most significant bit (Most Significant Bit, MSB) to a least significant bit (Least Significant Bit, LSB)) of FP32 data are added up, and an overflow bit is used as the threshold for random input. However, this mode describes only a single stochastic rounding conversion mode, includes only conversion from the FP32 data format to the FP16 or BF16 data format, and cannot meet conversion from high-precision data in another format to low-precision data. In addition, a large quantity of bits in the mantissa field are used in the threshold generation manner in this mode, leading to complex computing and high hardware overheads.

Therefore, in a floating-point data precision conversion method provided in embodiments of this application, conversion from high-precision data to low-precision data is implemented. During data format conversion, a sign field of second floating-point data may be obtained based on a sign field of first floating-point data, a prefix code field and a second exponent field of the second floating-point data may be obtained based on a first exponent field of the first floating-point data, and a second mantissa field of the second floating-point data may be obtained based on a first mantissa field of the first floating-point data. In the second floating-point data, a bit width of the second exponent field is indicated by the short prefix code field, so that precision or a bit width of a mantissa of the second floating-point data can be effectively improved. In addition, the second floating-point data that provides precision with only a one-digit mantissa may represent a large value range, so that a relationship between a bit width, a range, and precision of the second floating-point data is effectively balanced. In addition, the prefix code field may be encoded by using a prefix code and occupies a small bit width, and it is convenient to parse the second exponent field and the second mantissa field. In addition, a simple rounding mode is provided. A rounding operation is performed on a to-be-retained coded value based on a to-be-discarded coded value in the first mantissa field, without support from another device. This improves conversion efficiency of conversion from high-precision data to low-precision data, and reduces hardware overheads.

The second floating-point data provided in embodiments of this application is HiFloat8 data. Table 2 shows an encoding scheme for the HiFloat8 data.

**Table 2 Encoding scheme for the HiFloat8 data**

| HiFloat8 data | Sign field (S) | Prefix code field (D): {value} | Exponent field (E) | Mantissa field (M) |
|---|---|---|---|---|
| Bit width | 1 | 2:{2, 3, 4} | D | 8-3-D |
| | 1 | 3:{0, 1} | D | 8-4-D |

8 is a total bit width of the HiFloat8 data, and the total bit width may change. The sign field occupies one bit. 0 indicates a positive number, and 1 indicates a negative number; or 1 indicates a negative number, and 0 indicates a positive number. The prefix code field occupies two or three bits. The prefix code field may represent five pieces of different information, and a value (Value) of D may be 0, 1, 2, 3, or 4. A bit width of the exponent field varies based on the value of D, and the mantissa field occupies a remaining bit width.

The prefix code field may be encoded by using an integer (integer). In this case, D is a fixed value. The prefix code field may alternatively be encoded by using a prefix code (prefix code). In this case, D is a finite value set. During prefix code encoding, two bits are used to encode the values 2, 3, and 4, and three bits are used to encode the values 0 and 1. A prefix code encoding scheme for the prefix code field is shown in Table 3. Table 3 shows an encoding scheme for the prefix code field.

**Table 3 Prefix code encoding scheme for the prefix code field**

| Value | Code | Bit width |
|---|---|---|
| 4 | 11 | 2 |
| 3 | 10 | |
| 2 | 01 | |
| 1 | 001 | 3 |
| 0 | 000 | |

A formula provided in embodiments of this application for conversion between HiFloat8 data and a decimal value (X) is as follows: X=(-1)^{S}*2^{Eᵢ+E_{c}}*(1+M).

Ec is a center of symmetry of an exponent, and is also the bias in the FP32 data.

D being 0 indicates that a value of the exponent field is 0. When D is not 0, the exponent field is encoded by using a signed magnitude (signed magnitude), namely, a true form (True Form, TF) with a sign bit. A code of the exponent field is as follows: Ei={ Se, 1'b1, TF[2:end]}, where Se is a sign bit of an exponent bit. The most significant bit 1'b1 of the TF is hidden and not stored. In this case, a coded value of the exponent field is as follows: Es={ Se, TF[2:end]}. A decimal coded value corresponding to the exponent field is as follows: Ev=Ei+Ec.

HiFloat(N, 5, Ec) may be set to HiFloat(8, 5, 0), HiF8 for short, or may be set to other values. Table 4 shows distribution of HiFloat8 coded values.

**Table 4 HiFloat8 coded value distribution table**

| | | | | | |
|---|---|---|---|---|---|
| D | 0 | 1 | 2 | 3 | 4 |
| Es | None | Se | Se, TF[2] | Se, TF[2:3] | Se, TF[2:4] |
| Ei | 0 | Se, 1 | Se, 1, TF[2] | Se, 1, TF[2:3] | Se, 1, TF[2:4] |
| Ev | 0 | ±1 | ±[2, 3] | ±[4, 7] | ±[8, 15] |
| Bit width of M | 4 | 3 | 3 | 2 | 1 |

In the foregoing scenario, a floating-point data precision conversion method and apparatus in this application may be used in different systems or devices, for example, used in an execution device 20 shown in FIG. 2. FIG. 2 is a diagram of a system or a device in which a floating-point data precision conversion method and apparatus are used according to an embodiment of this application. The execution device may be a terminal, for example, a mobile phone terminal, a tablet computer, a notebook computer, an AR device (not shown in FIG. 2), a VR device (not shown in FIG. 2), or a vehicle-mounted terminal (not shown in FIG. 2), or may be a server or the like. The floating-point data precision conversion method provided in this application may be used in scenarios in which the execution device 20 performs mixed-precision computing, for example, in a CPU, HPC, and AI. For example, the method is used in a scalar computing unit, a vector computing unit, a matrix computing unit, and a tensor computing unit.

In some embodiments, the floating-point data precision conversion apparatus provided in this application may be a chip. For example, the chip is a system-on-a-chip (System-on-a-Chip, SoC). FIG. 3 is a diagram of a structure of an SoC according to an embodiment of this application. The SoC includes a processor, a memory, an I/O interface, and the like. The processor may be a single-core processor or a multi-core processor. After loading data and an application in the memory, the processor may process the data, for example, perform computing in this application. For example, when the data is FP32 data, a sign field, a prefix code field, a second exponent field, and a second mantissa field of second floating-point data may be determined by reading a sign field, a first exponent field, and a first mantissa field in the FP32 data.

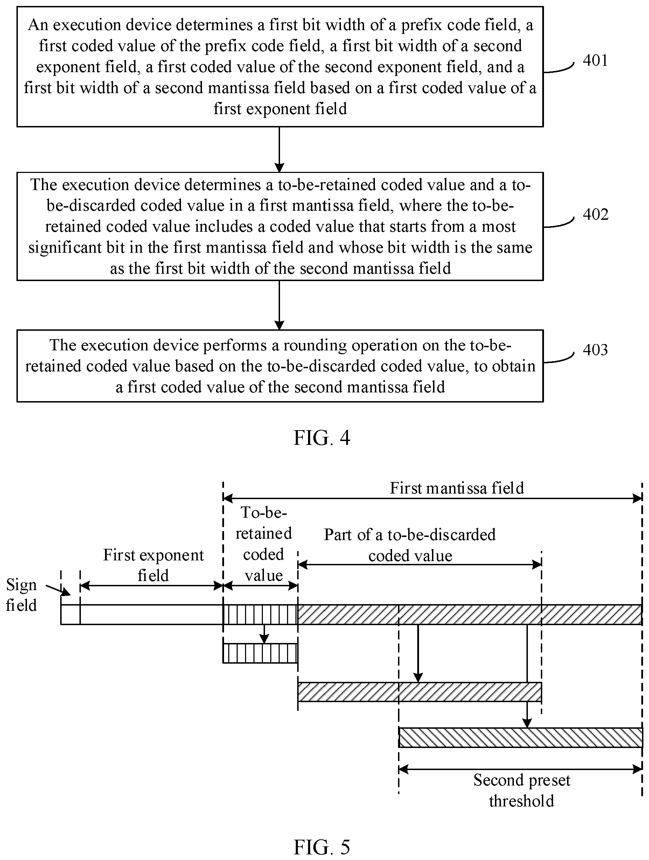

An embodiment of this application provides a floating-point data precision conversion method for converting first floating-point data into second floating-point data. The first floating-point data includes a sign field, a first exponent field, and a first mantissa field. The second floating-point data includes a sign field, a prefix code field, a second exponent field, and a second mantissa field. The prefix code field indicates a bit width of the second exponent field. Precision of the first floating-point data is higher than precision of the second floating-point data. FIG. 4 is a flowchart of a floating-point data precision conversion method according to an embodiment of this application. The method includes the following steps.

Step 401: An execution device determines a first bit width of the prefix code field, a first coded value of the prefix code field, a first bit width of the second exponent field, a first coded value of the second exponent field, and a first bit width of the second mantissa field based on a first coded value of the first exponent field.

For example, the precision of the first floating-point data is higher than the precision of the second floating-point data, where the first floating-point data may be FP32 data, and the second floating-point data may be HiFloat8 data.

During conversion, data format conversion does not affect positive/negative properties of floating-point data, and therefore the sign field of the first floating-point data is the same as the sign field of the second floating-point data. The first floating-point data or the second floating-point data includes a binary integer part and a binary decimal part. The first exponent field and the second exponent field determine a binary integer part of the first floating-point data and a binary integer part of the second floating-point data respectively. The first mantissa field determines a binary decimal part of the first floating-point data. The prefix code field and the second mantissa field determine a binary decimal part of the second floating-point data. A computing operation may be performed based on the first coded value of the first exponent field to obtain the first bit width of the prefix code field and the first coded value of the prefix code field. The first bit width of the second exponent field and the first coded value of the second exponent field may also be obtained based on a data format of the second floating-point data. The first bit width of the second mantissa field may be determined after the first bit width of the prefix code field and the first bit width of the second exponent field are obtained.

Step 402: The execution device determines a to-be-retained coded value and a to-be-discarded coded value in the first mantissa field, where the to-be-retained coded value includes a coded value that starts from a most significant bit in the first mantissa field and whose bit width is the same as the first bit width of the second mantissa field.

For example, because the precision of the first floating-point data is higher than the precision of the second floating-point data, a bit width of the first mantissa field of the first floating-point data is greater than a bit width of the second mantissa field of the second floating-point data. The first floating-point data is converted into the second floating-point data. Because the bit width of a second mantissa field of the second floating-point data is limited, a coded value in the first mantissa field needs to be rounded. The coded value that starts from the most significant bit in the first mantissa field and whose bit width is the same as the first bit width of the second mantissa field is determined as the to-be-retained coded value, and a remaining coded value in the first mantissa field other than the to-be-retained coded value is determined as the to-be-discarded coded value.

Step 403: The execution device performs a rounding operation on the to-be-retained coded value based on the to-be-discarded coded value, to obtain a first coded value of the second mantissa field.

For example, the rounding operation may be a carry operation and a discard operation, and whether to perform the carry operation on the to-be-retained coded value or perform the discard operation on the to-be-discarded coded value is determined based on the to-be-discarded coded value. In a determining manner, the to-be-discarded coded value is compared with a threshold. If the to-be-discarded coded value is greater than the threshold, the carry operation is performed on the to-be-retained coded value. If the to-be-discarded coded value is less than the threshold, the discard operation is performed on the to-be-discarded coded value.

For example, in the floating-point data precision conversion method provided in this embodiment of this application, conversion from high-precision data to low-precision data is implemented. During data format conversion, the sign field of the second floating-point data may be obtained based on the sign field of the first floating-point data, the prefix code field and the second exponent field of the second floating-point data may be obtained based on the first exponent field of the first floating-point data, and the second mantissa field of the second floating-point data may be obtained based on the first mantissa field of the first floating-point data. In the second floating-point data, the bit width of the second exponent field is indicated by the short prefix code field, so that the second floating-point data can provide maximum precision with a four-digit mantissa. In addition, the second floating-point data that provides precision with only a one-digit mantissa may represent a large value range, so that a relationship between a bit width, a range, and precision of the second floating-point data is effectively balanced. In addition, the prefix code field may be encoded by using a prefix code and occupies a small bit width, and it is convenient to parse the second exponent field and the second mantissa field. In addition, a simple rounding mode is provided. The rounding operation is performed on the to-be-retained coded value based on the to-be-discarded coded value in the first mantissa field, without support from another device. This improves conversion efficiency of conversion from high-precision data to low-precision data, and reduces hardware overheads.

Optionally, an embodiment of this application further provides a stochastic rounding (Stochastic Rounding, SR) mode. FIG. 5 is a diagram of a structure of a stochastic rounding mode according to an embodiment of this application. Step 403 may further include the following steps.

Step 4033: When a coded value that starts from a most significant bit in the to-be-discarded coded value and whose bit width is a preset bit width is greater than or equal to a second preset threshold, the execution device performs a carry operation on a least significant bit of the to-be-retained coded value, and performs a discard operation on the to-be-discarded coded value, where a coded value obtained through the carry operation on the to-be-retained coded value is the first coded value of the second mantissa field.

Step 4034: When a coded value that starts from a most significant bit in the to-be-discarded coded value and whose bit width is a preset bit width is less than a second preset threshold, the execution device performs a discard operation on the to-be-discarded coded value, where the to-be-retained coded value is the first coded value of the second mantissa field.

The second preset threshold is a coded value that starts from a least significant bit in the to-be-discarded coded value and whose bit width is a preset bit width.

For example, in the SR mode, the preset bit width may be an integer ranging from 10 to 14. For example, the preset bit width is 14. The second preset threshold may be a coded value that starts from the least significant bit in the to-be-discarded coded value and whose bit width is 14. In this case, a part of the to-be-discarded coded value, in the to-be-discarded coded value, that is used to be compared with the second preset threshold is a coded value that starts from the most significant bit and whose bit width is 14.

In an example, for the first mantissa field 23'b01000000000000000000000 in Table 1, if the first bit width of the second mantissa field is 2, the to-be-retained coded value in the first mantissa field is 2'b01, and the to-be-discarded coded value is 21'b000000000000000000000. In this case, the part of the to-be-discarded coded value is 14'b00000000000000, and the second preset threshold is 14'b00000000000000. Because the part of the to-be-discarded coded value is equal to the second preset threshold, the discard operation is performed on the to-be-discarded coded value. The coded value obtained through the carry operation on the to-be-retained coded value is the first coded value of the second mantissa field. In other words, the first coded value of the second mantissa field is 2'b01.

In another example, for the first mantissa field 23'b01000000000000000000000 in Table 1, if the first bit width of the second mantissa field is 1, the to-be-retained coded value in the first mantissa field is 1'b0, and the to-be-discarded coded value is 22'b1000000000000000000000. In this case, the part of the to-be-discarded coded value is 14'b10000000000000, and the second preset threshold is 14'b00000000000000. Because the part of the to-be-discarded coded value is greater than the second preset threshold, the carry operation is performed on the least significant bit of the to-be-retained coded value, and the discard operation is performed on the to-be-discarded coded value. The coded value obtained through the carry operation on the to-be-retained coded value is the first coded value of the second mantissa field. In other words, the first coded value of the second mantissa field is 1'b1.

For example, in the SR mode, the second preset threshold used for comparison is a coded value that starts from the least significant bit in the to-be-discarded coded value and whose bit width is the preset bit width. The second preset threshold is generated without an additional random number generator, and random number generation has no performance bottleneck, so that efficiency of conversion from high-precision data to low-precision data is improved, and hardware overheads are lower.

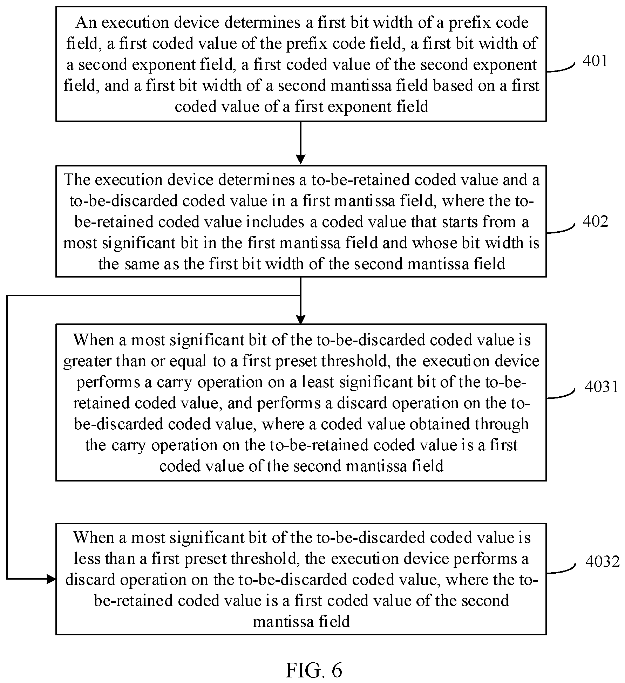

Optionally, the rounding operation includes a carry operation or a discard operation. This embodiment of this application provides a rounding mode of rounding half to away (Round Half To Away, TA). FIG. 6 is a flowchart of a rounding mode of rounding half to away according to an embodiment of this application. Step 403 may include the following steps.

Step 4031: When a most significant bit of the to-be-discarded coded value is greater than or equal to a first preset threshold, the execution device performs a carry operation on a least significant bit of the to-be-retained coded value, and performs a discard operation on the to-be-discarded coded value, where a coded value obtained through the carry operation on the to-be-retained coded value is the first coded value of the second mantissa field.

Step 4032: When a most significant bit of the to-be-discarded coded value is less than a first preset threshold, the execution device performs a discard operation on the to-be-discarded coded value, where the to-be-retained coded value is the first coded value of the second mantissa field.

For example, in the TA rounding mode, the first preset threshold may be 1. When the most significant bit of the to-be-discarded coded value is greater than or equal to the preset threshold, in other words, when the most significant bit of the to-be-discarded coded value is 1, the carry operation is performed on the least significant bit of the to-be-retained coded value, and the discard operation is performed on the to-be-discarded coded value. When the most significant bit of the to-be-discarded coded value is less than the first preset threshold, in other words, when the most significant bit of the to-be-discarded coded value is 0, the discard operation is performed on the to-be-discarded coded value.

In an example, for the first mantissa field 23'b01000000000000000000000 in Table 1, if the first bit width of the second mantissa field is 2, the to-be-retained coded value in the first mantissa field is 2'b01, and the to-be-discarded coded value is 21'b000000000000000000000. In this case, the most significant bit of the to-be-discarded coded value is 0. Because the most significant bit of the to-be-discarded coded value is less than the first preset threshold, the discard operation is performed on the to-be-discarded coded value. The to-be-retained coded value is the first coded value of the second mantissa field. In other words, the first coded value of the second mantissa field is 2'b01.

In another example, for the first mantissa field 23'b01000000000000000000000 in Table 1, if the first bit width of the second mantissa field is 1, the to-be-retained coded value in the first mantissa field is 1'b0, and the to-be-discarded coded value is 22'b1000000000000000000000. In this case, the most significant bit of the to-be-discarded coded value is 1. Because the most significant bit of the to-be-discarded coded value is greater than the first preset threshold, the carry operation is performed on the least significant bit of the to-be-retained coded value, and the discard operation is performed on the to-be-discarded coded value. The coded value obtained through the carry operation on the to-be-retained coded value is the first coded value of the second mantissa field. In other words, the first coded value of the second mantissa field is 1'b1.

For example, in the TA rounding mode, the preset threshold may alternatively be 0. When the most significant bit of the to-be-discarded coded value is greater than the first preset threshold, the carry operation is performed on the least significant bit of the to-be-retained coded value, the discard operation is performed on the to-be-discarded coded value, and the coded value obtained through the carry operation on the to-be-retained coded value is the first coded value of the second mantissa field. When the most significant bit of the to-be-discarded coded value is less than or equal to the first preset threshold, the discard operation is performed on the to-be-discarded coded value, and the to-be-retained coded value is the first coded value of the second mantissa field.

For example, in addition to the TA rounding mode, a rounding mode of rounding half to even (rounding half to even) and a rounding mode of rounding half to odd (rounding half to odd) may be further included. Compared with other rounding modes, the TA rounding mode provided in this embodiment of this application has a smaller hardware implementation area, lower power consumption overheads, and a higher data resolution.

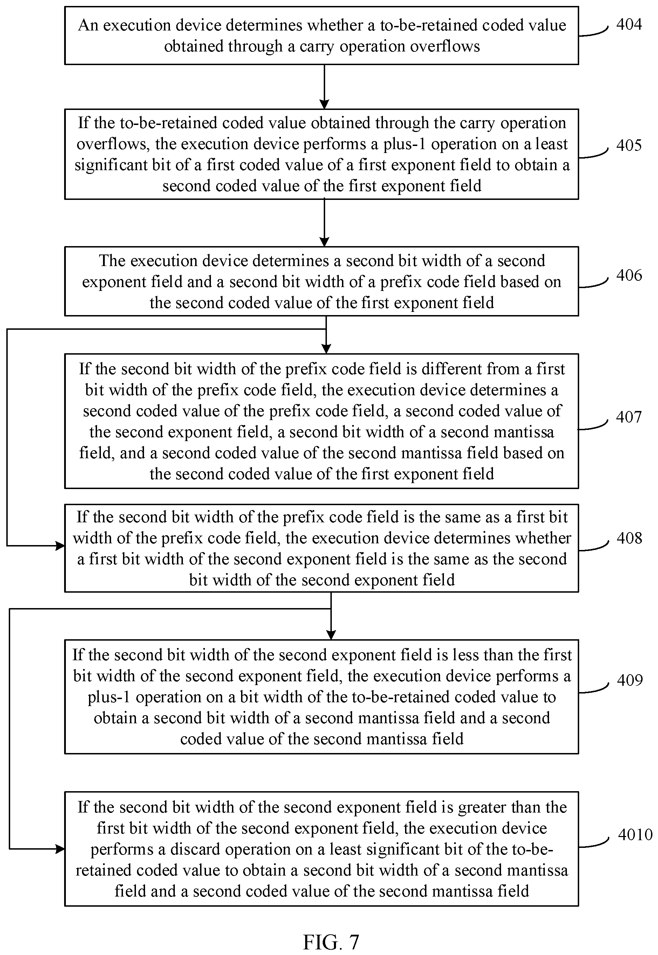

Optionally, FIG. 7 is a flowchart of another floating-point data precision conversion method according to an embodiment of this application. The floating-point data precision conversion method provided in this embodiment of this application may further include the following steps.

Step 404: The execution device determines whether the to-be-retained coded value obtained through the carry operation overflows.

For example, if the carry operation is performed on the to-be-retained coded value, the to-be-retained coded value may overflow. In an example, if the to-be-retained coded value is 3'b111, an overflow phenomenon occurs after the carry operation is performed on the least significant bit of the to-be-retained coded value.

Step 405: If the to-be-retained coded value obtained through the carry operation overflows, the execution device performs a plus-1 operation on a least significant bit of the first coded value of the first exponent field to obtain a second coded value of the first exponent field.

For example, as shown in Table 1, the first coded value of the first exponent field is 8'b01111100. If the to-be-retained coded value obtained through the carry operation overflows, the plus-1 operation is performed on the least significant bit of the first coded value of the first exponent field to obtain the second coded value of the first exponent field. To be specific, the second coded value of the first exponent field is 8'b01111101.

Step 406: The execution device determines a second bit width of the second exponent field and a second bit width of the prefix code field based on the second coded value of the first exponent field.

For example, based on the second coded value 8'b01111101 of the first exponent field, it can be learned that the second bit width of the second exponent field is 1 and the second bit width of the prefix code field is 3.

Step 407: If the second bit width of the prefix code field is different from the first bit width of the prefix code field, the execution device determines a second coded value of the prefix code field, a second coded value of the second exponent field, a second bit width of the second mantissa field, and a second coded value of the second mantissa field based on the second coded value of the first exponent field.

For example, as shown in Table 4, if the second bit width of the prefix code field is different from the first bit width of the prefix code field, because the prefix code field indicates the bit width of the second exponent field, the first bit width of the second exponent field is different from the second bit width of the second exponent field. If the second bit width of the prefix code field is greater than the first bit width of the prefix code field, the second bit width of the second exponent field is less than the first bit width of the second exponent field. In this case, an increased bit width amount of the prefix code field is the same as a reduced bit width amount of the second exponent field. Therefore, the first bit width of the second mantissa field remains unchanged. If the second bit width of the prefix code field is less than the first bit width of the prefix code field, the second bit width of the second exponent field is greater than the first bit width of the second exponent field. In this case, a reduced bit width amount of the prefix code field is the same as a reduced bit width amount of the second exponent field. Therefore, the first bit width of the second mantissa field remains unchanged. Therefore, if the second bit width of the prefix code field is different from the first bit width of the prefix code field, bit widths of the second exponent field and the prefix code field change, and the second bit width of the second mantissa field remains unchanged. The execution device determines the second coded value of the prefix code field and the second coded value of the second exponent field based on the second coded value of the first exponent field. The second coded value of the second mantissa field is all 0s. For example, if the second bit width of the second mantissa field is 3, the second coded value of the second mantissa field is 3'b000.

In an example, it is determined, based on the first bit 8'b01111100 of the first exponent field, that the first bit width of the prefix code field is 2 and the second bit width of the second exponent field is 2. In this case, a reduced bit width amount of the prefix code field is the same as an increased bit width amount of the second exponent field. Therefore, the first bit width of the second mantissa field remains unchanged.

Step 408: If the second bit width of the prefix code field is the same as the first bit width of the prefix code field, the execution device determines whether the first bit width of the second exponent field is the same as the second bit width of the second exponent field.

Step 409: If the second bit width of the second exponent field is less than the first bit width of the second exponent field, the execution device performs a plus-1 operation on a bit width of the to-be-retained coded value to obtain a second bit width of the second mantissa field and a second coded value of the second mantissa field.

For example, the second bit width of the prefix code field is the same as the first bit width of the prefix code field. If the second bit width of the second exponent field is less than the first bit width of the second exponent field, the first bit width of the second mantissa field increases. The plus-1 operation is performed on the bit width of the to-be-retained coded value to obtain the second bit width of the second mantissa field and the second coded value of the second mantissa field. In an example, if the to-be-retained coded value is 2'b01 and the bit width of the to-be-retained coded value is 2, after the plus-1 operation is performed on the bit width of the to-be-retained coded value, a bit width of the to-be-retained coded value is 3, and the to-be-retained coded value is 3'b010.

Step 4010: If the second bit width of the second exponent field is greater than the first bit width of the second exponent field, the execution device performs a discard operation on the least significant bit of the to-be-retained coded value to obtain a second bit width of the second mantissa field and a second coded value of the second mantissa field.

For example, the second bit width of the prefix code field is the same as the first bit width of the prefix code field. If the second bit width of the second exponent field is greater than the first bit width of the second exponent field, the first bit width of the second mantissa field decreases. The discard operation is performed on the least significant bit of the to-be-retained coded value to obtain the second bit width of the second mantissa field and the second coded value of the second mantissa field. In an example, if the to-be-retained coded value is 2'b01 and the bit width of the to-be-retained coded value is 2, after the discard operation is performed on the least significant bit of the to-be-retained coded value, the to-be-retained coded value is 1'b0, and a bit width of the to-be-retained coded value is 1.

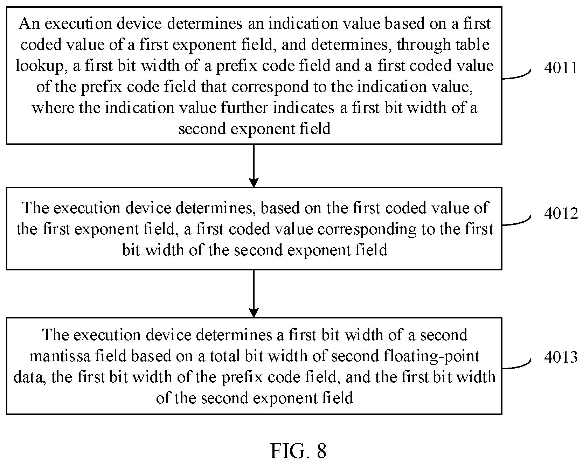

The following further describes the floating-point data precision conversion method provided in this application. FIG. 8 is a flowchart of another floating-point data precision conversion method according to an embodiment of this application. The step 401 includes the following steps.

Step 4011: The execution device determines an indication value based on the first coded value of the first exponent field, and determines, through table lookup, the first bit width of the prefix code field and the first coded value of the prefix code field that correspond to the indication value, where the indication value further indicates the first bit width of the second exponent field.

For example, an exponential value N of the first exponent field may be determined based on the first coded value of the first exponent field, and the indication value may be determined based on the exponential value of the first exponent field. The table lookup herein means lookup in Table 3. The indication value is a value of D, and the indication value may be 0, 1, 2, 3, or 4. In an example, as shown in Table 1, the first coded value of the first exponent field is 8'b01111100, which indicates 124 in decimal. After a bias 127 for FP32 data is removed, -3 in decimal is obtained. -3 is the exponential value N of the first exponent field. Based on a formula D=INT[log₂|N|], it can be learned that D is 2. It can be determined, through lookup in Table 3, that the first bit width of the prefix code field and the first coded value of the prefix code field that correspond to 2 are 2 and 01 respectively. The indication value further indicates the first bit width of the second exponent field. To be specific, the first bit width of the second exponent field is 2.

Step 4012: The execution device determines, based on the first coded value of the first exponent field, the first coded value corresponding to the first bit width of the second exponent field.

For example, for the first exponent field in Table 1, as shown in Table 4, when D is 2 and the exponential value of the first exponent field is -3, in other words, a sign bit Se of an exponent bit is 1, because the first bit width of the second exponent field that is determined by the indication value is 2, the determined first coded value of the second exponent field is 11.

Step 4013: The execution device determines the first bit width of the second mantissa field based on a total bit width of the second floating-point data, the first bit width of the prefix code field, and the first bit width of the second exponent field.

For example, the total bit width of the second floating-point data is Nb, the first bit width of the prefix code field is Db, the first bit width of the second exponent field is Eb, a bit width of the sign field is 1, and the first bit width of the second mantissa field is Mb. In this case, Mb=Nb-Db-Eb-1. In an example, for HiFloat8 data, Nb=8, and Db=2 or 3. In this case, the first bit width of the second mantissa field is as follows: Mb=Nb-3-Eb, or Mb=Nb-Eb-4.

For example, for the second floating-point data in a HiFloat8 data format, a bit width of the sign field is 1, a bit width of the prefix code field is 2 or 3, the first bit width of the second exponent field is an integer ranging from 0 to 4, and the first bit width of the second mantissa field is an integer ranging from 1 to 4. Therefore, in the second floating-point data, the first bit width of the second exponent field is indicated by the short prefix code field, so that the second floating-point data can provide maximum precision with a four-digit mantissa. In addition, the second floating-point data that provides precision with only a one-digit mantissa may represent a large value range, so that a relationship between a bit width, a range, and precision of the second floating-point data is effectively balanced. In addition, a most significant bit is hidden when the second exponent field is stored, so that the first bit width, which needs to be stored, of the second exponent field is reduced. This effectively avoids a problem that values of first coded values of second exponent fields corresponding to indication values of different prefix code fields overlap, so that the HiFloat8 data format does not include redundant codes.

Optionally, when the first floating-point data exceeds an upper limit of a data range of the second floating-point data, the second floating-point data is determined in a saturation mode or an infinity mode.

For example, in the saturation mode, maximum floating-point data that can be represented by low-precision floating-point data may be used as the first floating-point data. In the infinity mode, infinite data of low-precision floating-point data may be used as the first floating-point data. In an example, for HiFloat8 data, if the first floating-point data exceeds an upper limit of a data range of the HiFloat8 data, the second floating-point data obtained through precision conversion on the first floating-point data may be represented as 8'b01101111.

Optionally, when the first floating-point data exceeds a lower limit of a data range of the second floating-point data, the second floating-point data is zero.

For example, for HiFloat8 data, if the first floating-point data exceeds a lower limit of a data range of the HiFloat8 data, the second floating-point data is zero, and the second floating-point data may be represented as 8'b01111110.

Optionally, when the first floating-point data is not a number, the second floating-point data is not a number.

For example, for HiFloat8 data, if the first floating-point data is not a number (Not a Number, NAN), the second floating-point data may be represented as 8'b11111110.

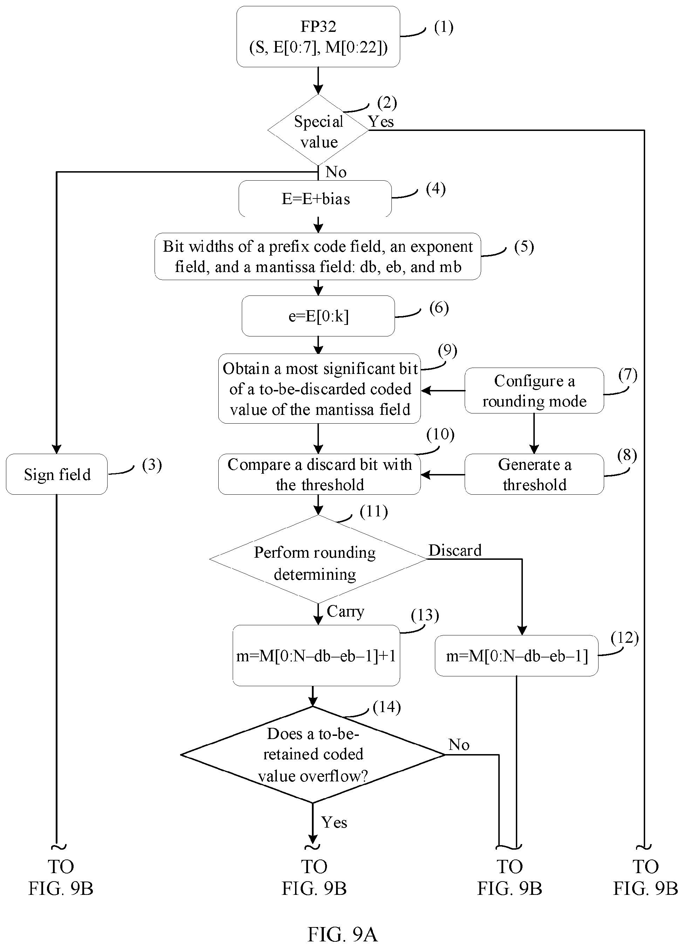

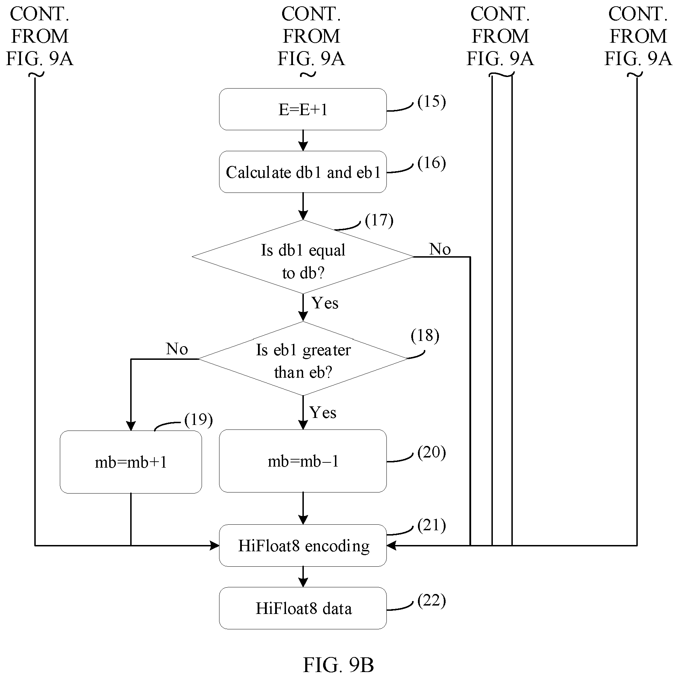

For example, FIG. 9A and FIG. 9B are a flowchart of converting FP32 data into HiFloat8 data according to an embodiment of this application. For example, conversion from FP32 data to HiFloat8 data is performed by a conversion module. The conversion process includes the following process:
(1) The conversion module receives the FP32 data, where the FP32 data includes a sign field S, an exponent field E[0:7], and a mantissa field M[0:22].
(2) Determine whether the FP32 data is a special value (a zero value, not a number (Not a Number, NAN), approaching positive infinity, or approaching negative infinity). If the FP32 data is a special value, perform (21).
(3) If the FP32 data is not a special value, obtain the sign field of the FP32 data and perform (21).
(4) Perform a bias removal operation on the exponent field of the FP32 data: E=E+bias.
(5) Calculate bit widths respectively corresponding to a prefix code field, an exponent field, and a mantissa field of the HiFloat8 data, and denote the bit widths as db, eb, and mb respectively.
(6) Determine a coded value of the exponent field of the HiFloat8 data based on the exponent field of the FP32 data and the bit width of the exponent field of the HiFloat8 data: e=E[0:k] where k is a value corresponding to the bit width of the exponent field of the HiFloat8 data.
(7) Configure a rounding mode.
(8) Generate a threshold.
(9) Obtain a most significant bit of a to-be-discarded coded value of the mantissa field of the FP32 data as a discard bit.
(10) Compare the discard bit with the threshold.
(11) Perform rounding determining. If the discard bit is greater than the threshold, perform a carry operation. If discard bit is less than the threshold, perform a discard operation.
(12) If the discard operation is performed, a to-be-retained coded value of the mantissa field of the FP32 data is the mantissa field of the HiFloat8 data: m=M[0:N-db-eb-1]. Perform (21).
(13) If the carry operation is performed, perform a plus-1 operation on a to-be-retained coded value of the mantissa field of the FP32 data: m=M[0:N-db-eb-1]+1.
(14) Determine whether the to-be-retained coded value of the mantissa field of the FP32 data overflows. If the to-be-retained coded value of the mantissa field of the FP32 data does not overflow, perform (21).
(15) If the to-be-retained coded value of the mantissa field of the FP32 data overflows, perform a plus-1 operation on the exponent field of the FP32 data: E=E+1.
(16) Calculate a new bit width of the prefix code field and a new bit width of the exponent field of the HiFloat8 data based on an exponent field of the FP32 that is obtained through the plus-1 operation, and denote the new bit widths as db1 and eb1 respectively.
(17) Determine whether db1 is equal to db. If db1 is not equal to db, perform (21).
(18) If db1 is equal to db, determine whether eb1 is greater than eb.
(19) If eb1 is less than eb, perform a plus-1 operation on the bit width of the mantissa field of the HiFloat8 data: mb=mb+1.
(20) If eb1 is greater than eb, perform a minus-1 operation on the bit width of the mantissa field of the HiFloat8 data: mb=mb-1.
(21) Perform HiFloat8 data encoding.
(22) Obtain the HiFloat8 data.

It can be understood that, to implement the foregoing functions, an electronic device includes corresponding hardware and/or software modules for performing the functions. With reference to algorithm steps of examples described in embodiments disclosed in this specification, this application can be implemented in a form of hardware or a combination of hardware and computer software. Whether a function is performed by hardware or hardware driven by computer software depends on particular applications and design constraints of technical solutions. A person skilled in the art may use different methods to implement the described functions for each specific application with reference to embodiments. However, it should not be considered that the implementation goes beyond the scope of this application.

In embodiments, the electronic device may be divided into functional modules based on the foregoing method examples. For example, each functional module may be obtained through division based on each corresponding function, or two or more functions may be integrated into one processing module. The integrated module may be implemented in a form of hardware. It should be noted that division into the modules in embodiments is an example and is merely logical function division. During actual implementation, another division manner may be used.

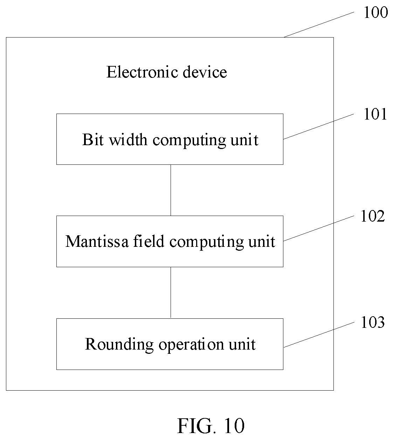

When each functional module is obtained through division based on each corresponding function, FIG. 10 is a diagram of a possible composition of the electronic device 100 in the foregoing embodiments. FIG. 10 is a diagram of a structure of an electronic device according to an embodiment of this application. The electronic device 100 may include a bit width computing unit 101, a mantissa field computing unit 102, and a rounding operation unit 103.

The bit width computing unit 101 may be configured to support the electronic device 100 in performing step 401, step 4011, step 4012, step 4013, and the like, and/or another process of the technology described in this specification.

The mantissa field computing unit 102 may be configured to support the electronic device 100 in performing step 402 and the like, and/or another process of the technology described in this specification.

The rounding operation unit 103 may be configured to support the electronic device 100 in performing step 403, step 4031, step 4032, and the like, and/or another process of the technology described in this specification.

It should be noted that all related content of the steps in the foregoing method embodiments may be cited in function descriptions of corresponding functional modules. Details are not described herein again.

The electronic device 100 provided in this embodiment is configured to perform the foregoing floating-point data precision conversion method, and therefore can achieve the same effect as the foregoing implementation methods.

When an integrated unit is used, the electronic device 100 may include a processing module, a storage module, and a communication module. The processing module may be configured to control and manage actions of the electronic device 100. For example, the processing module may be configured to support the electronic device 100 in performing the steps performed by the bit width computing unit 101, the mantissa field computing unit 102, and the rounding operation unit 103. The storage module may be configured to support the electronic device 100 in storing program code, data, and the like. The communication module may be configured to support the electronic device 100 in communicating with another device, for example, a wireless access device.

The processing module may be a processor or a controller. The processing module may implement or execute various example logical blocks, modules, and circuits described with reference to content disclosed in this application. The processor may alternatively be a combination for implementing a computing function, for example, a combination including one or more microprocessors or a combination of a digital signal processor (digital signal processor, DSP) and a microprocessor. The storage module may be a memory. The communication module may be specifically a device, for example, a radio frequency circuit, a Bluetooth chip, or a Wi-Fi chip, that interacts with another electronic device.

In an embodiment, when the processing module is a processor and the storage module is a memory, the electronic device in this embodiment may be a server, a computer, or the like.

An embodiment of this application further provides an electronic device, including one or more processors and one or more memories. The one or more memories are coupled to the one or more processors. The one or more memories are configured to store computer program code, and the computer program code includes computer instructions. When the one or more processors execute the computer instructions, the electronic device is enabled to perform the foregoing related method steps, to implement the floating-point data precision conversion method in the foregoing embodiments.

An embodiment of this application further provides a computer storage medium. The computer storage medium stores computer instructions. When the computer instructions are run on an electronic device, the electronic device is enabled to perform the foregoing related method steps, to implement the floating-point data precision conversion method in the foregoing embodiments.

An embodiment of this application further provides a computer program product. When the computer program product is run on a computer, the computer is enabled to perform the foregoing related steps, to implement the floating-point data precision conversion method performed by the electronic device in the foregoing embodiments.

In addition, an embodiment of this application further provides an apparatus. The apparatus may be specifically a chip, a component, or a module. The apparatus may include a processor and a memory that are connected to each other. The memory is configured to store computer-executable instructions. When the apparatus runs, the processor may execute the computer-executable instructions stored in the memory, so that the chip performs the floating-point data precision conversion method performed by the electronic device in the foregoing method embodiments.

The electronic device, the computer storage medium, the computer program product, or the chip provided in embodiments is configured to perform the corresponding method provided above. Therefore, for benefits that can be achieved, refer to the benefits of the corresponding method provided above. Details are not described herein again.

Based on the descriptions of the foregoing implementations, a person skilled in the art may understand that, for a purpose of convenient and brief description, division into the foregoing functional modules is merely used as an example for illustration. During practical application, the foregoing functions may be allocated to different functional modules and implemented according to a requirement. In other words, an inner structure of an apparatus is divided into different functional modules to implement all or some of the functions described above.

In several embodiments provided in this application, it should be understood that the disclosed apparatus and method may be implemented in other manners. For example, the described apparatus embodiment is merely an example. For example, division into the modules or units is merely logical function division, and may be other division during actual implementation. For example, a plurality of units or components may be combined or may be integrated into another apparatus, or some features may be ignored or not performed. In addition, the shown or discussed mutual couplings or direct couplings or communication connections may be implemented through some interfaces. The indirect couplings or communication connections between the apparatuses or units may be implemented in electrical, mechanical, or other forms.

The units described as separate components may or may not be physically separated, and components shown as units may be one or more physical units, to be specific, may be located in one place, or may be distributed in a plurality of different places. Some or all of the units may be selected according to actual requirements to achieve objectives of solutions of embodiments.

In addition, functional units in embodiments of this application may be integrated into one processing unit, or each unit may exist alone physically, or two or more units may be integrated into one unit. The integrated unit may be implemented in a form of hardware, or may be implemented in a form of a software functional unit.

When the integrated unit is implemented in a form of a software functional unit and sold or used as an independent product, the integrated unit may be stored in a readable storage medium. Based on such an understanding, technical solutions in embodiments of this application essentially, or a part contributing to the conventional technology, or all or some of the technical solutions may be implemented in a form of a software product. The software product is stored in a storage medium and includes several instructions for enabling a device (which may be a single-chip microcomputer, a chip, or the like) or a processor (processor) to perform all or some of steps of methods in embodiments of this application. The storage medium includes any medium that can store program code, for example, a USB flash drive, a removable hard disk, a read only memory (read-only memory, ROM), a random access memory (random access memory, RAM), a magnetic disk, or a compact disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A floating-point data precision conversion method, wherein first floating-point data comprises a sign field, a first exponent field, and a first mantissa field, second floating-point data comprises the sign field, a prefix code field, a second exponent field, and a second mantissa field, the prefix code field indicates a bit width of the second exponent field, precision of the first floating-point data is higher than precision of the second floating-point data, and the method comprises:
determining a first bit width of the prefix code field, a first coded value of the prefix code field, a first bit width of the second exponent field, a first coded value of the second exponent field, and a first bit width of the second mantissa field based on a first coded value of the first exponent field;
determining a to-be-retained coded value and a to-be-discarded coded value in the first mantissa field, wherein the to-be-retained coded value comprises a coded value that starts from a most significant bit in the first mantissa field and whose bit width is the same as the first bit width of the second mantissa field; and
performing a rounding operation on the to-be-retained coded value based on the to-be-discarded coded value, to obtain a first coded value of the second mantissa field.

2. The method according to claim 1, wherein the rounding operation comprises a carry operation and a discard operation, and the performing a rounding operation on the to-be-retained coded value based on the to-be-discarded coded value, to obtain a first coded value of the second mantissa field comprises:
when a coded value that starts from a most significant bit in the to-be-discarded coded value and whose bit width is a preset bit width is greater than or equal to a second preset threshold, performing a carry operation on a least significant bit of the to-be-retained coded value, and performing a discard operation on the to-be-discarded coded value, wherein a coded value obtained through the carry operation on the to-be-retained coded value is the first coded value of the second mantissa field; or
when a coded value that starts from a most significant bit in the to-be-discarded coded value and whose bit width is a preset bit width is less than a second preset threshold, performing a discard operation on the to-be-discarded coded value, wherein the to-be-retained coded value is the first coded value of the second mantissa field, wherein
the second preset threshold is a coded value that starts from a least significant bit in the to-be-discarded coded value and whose bit width is a preset bit width.

3. The method according to claim 1, wherein the rounding operation comprises a carry operation or a discard operation, and the performing a rounding operation on the to-be-retained coded value based on the to-be-discarded coded value, to obtain a first coded value of the second mantissa field comprises:
when a most significant bit of the to-be-discarded coded value is greater than or equal to a first preset threshold, performing a carry operation on a least significant bit of the to-be-retained coded value, and performing a discard operation on the to-be-discarded coded value, wherein a coded value obtained through the carry operation on the to-be-retained coded value is the first coded value of the second mantissa field; or
when a most significant bit of the to-be-discarded coded value is less than a first preset threshold, performing a discard operation on the to-be-discarded coded value, wherein the to-be-retained coded value is the first coded value of the second mantissa field.

4. The method according to claim 2 or 3, wherein the method further comprises:
determining whether the to-be-retained coded value obtained through the carry operation overflows;
if the to-be-retained coded value obtained through the carry operation overflows, performing a plus-1 operation on a least significant bit of the first coded value of the first exponent field to obtain a second coded value of the first exponent field;
determining a second bit width of the second exponent field and a second bit width of the prefix code field based on the second coded value of the first exponent field; and
if the second bit width of the prefix code field is different from the first bit width of the prefix code field, determining a second coded value of the prefix code field, a second coded value of the second exponent field, a second bit width of the second mantissa field, and a second coded value of the second mantissa field based on the second coded value of the first exponent field; or
if the second bit width of the prefix code field is the same as the first bit width of the prefix code field, determining whether the first bit width of the second exponent field is the same as the second bit width of the second exponent field; and
if the second bit width of the second exponent field is less than the first bit width of the second exponent field, performing a plus-1 operation on a bit width of the to-be-retained coded value to obtain a second bit width of the second mantissa field and a second coded value of the second mantissa field; or
if the second bit width of the second exponent field is greater than or equal to the first bit width of the second exponent field, performing a discard operation on the least significant bit of the to-be-retained coded value to obtain a second bit width of the second mantissa field and a second coded value of the second mantissa field.

5. The method according to claim 1, wherein the determining a first bit width of the prefix code field, a first coded value of the prefix code field, a first bit width of the second exponent field, and a first coded value of the second exponent field based on a first coded value of the first exponent field comprises:
determining an indication value based on the first coded value of the first exponent field, and determining, through table lookup, the first bit width of the prefix code field and the first coded value of the prefix code field that correspond to the indication value, wherein the indication value further indicates the first bit width of the second exponent field; and
determining, based on the first coded value of the first exponent field, the first coded value corresponding to the first bit width of the second exponent field.

6. The method according to claim 1 or 5, wherein the determining a first bit width of the second mantissa field based on a first coded value of the first exponent field comprises:
determining the first bit width of the second mantissa field based on a total bit width of the second floating-point data, the first bit width of the prefix code field, and the first bit width of the second exponent field.

7. The method according to claim 1, wherein the method further comprises:
when the first floating-point data exceeds an upper limit of a data range of the second floating-point data, determining the second floating-point data in a saturation mode or an infinity mode;
when the first floating-point data exceeds a lower limit of a data range of the second floating-point data, the second floating-point data is zero; or
when the first floating-point data is not a number, the second floating-point data is not a number.

8. A floating-point data precision conversion apparatus, wherein first floating-point data comprises a sign field, a first exponent field, and a first mantissa field, second floating-point data comprises the sign field, a prefix code field, a second exponent field, and a second mantissa field, the prefix code field indicates a bit width of the second exponent field, precision of the first floating-point data is higher than precision of the second floating-point data, and the apparatus comprises:
a bit width computing unit, configured to determine a first bit width of the prefix code field, a first coded value of the prefix code field, a first bit width of the second exponent field, a first coded value of the second exponent field, and a first bit width of the second mantissa field based on a first coded value of the first exponent field;
a mantissa field computing unit, configured to determine a to-be-retained coded value and a to-be-discarded coded value in the first mantissa field, wherein the to-be-retained coded value comprises a coded value that starts from a most significant bit in the first mantissa field and whose bit width is the same as the first bit width of the second mantissa field; and
a rounding operation unit, configured to perform a rounding operation on the to-be-retained coded value based on the to-be-discarded coded value, to obtain a first coded value of the second mantissa field.

9. The apparatus according to claim 8, wherein the rounding operation comprises a carry operation or a discard operation, and the rounding operation unit is further configured to:
when a coded value that starts from a most significant bit in the to-be-discarded coded value and whose bit width is a preset bit width is greater than or equal to a second preset threshold, perform a carry operation on a least significant bit of the to-be-retained coded value, and perform a discard operation on the to-be-discarded coded value, wherein a coded value obtained through the carry operation on the to-be-retained coded value is the first coded value of the second mantissa field; or
when a coded value that starts from a most significant bit in the to-be-discarded coded value and whose bit width is a preset bit width is less than a second preset threshold, perform a discard operation on the to-be-discarded coded value, wherein the to-be-retained coded value is the first coded value of the second mantissa field, wherein
the second preset threshold is a coded value that starts from a least significant bit in the to-be-discarded coded value and whose bit width is a preset bit width.

10. The apparatus according to claim 8, wherein the rounding operation comprises a carry operation or a discard operation, and the rounding operation unit is further configured to:
when a most significant bit of the to-be-discarded coded value is greater than or equal to a first preset threshold, perform a carry operation on a least significant bit of the to-be-retained coded value, and perform a discard operation on the to-be-discarded coded value, wherein a coded value obtained through the carry operation on the to-be-retained coded value is the first coded value of the second mantissa field; or
when a most significant bit of the to-be-discarded coded value is less than a first preset threshold, perform a discard operation on the to-be-discarded coded value, wherein the to-be-retained coded value is the first coded value of the second mantissa field.

11. The apparatus according to claim 9 or 10, wherein the apparatus further comprises:
an overflow unit, configured to determine whether the to-be-retained coded value obtained through the carry operation overflows, wherein
the bit width computing unit is further configured to: if the to-be-retained coded value obtained through the carry operation overflows, perform a plus-1 operation on the first coded value of the first exponent field to obtain a second coded value of the first exponent field;
determine a second bit width of the second exponent field and a second bit width of the prefix code field based on the second coded value of the first exponent field; and
if the second bit width of the prefix code field is different from the first bit width of the prefix code field, determine a second coded value of the prefix code field, a second coded value of the second exponent field, a second bit width of the second mantissa field, and a second coded value of the second mantissa field based on the second coded value of the first exponent field; or
if the second bit width of the prefix code field is the same as the first bit width of the prefix code field, determine whether the first bit width of the second exponent field is the same as the second bit width of the second exponent field; and
if the second bit width of the second exponent field is less than the first bit width of the second exponent field, perform a plus-1 operation on a bit width of the to-be-retained coded value to obtain a second bit width of the second mantissa field and a second coded value of the second mantissa field; or
if the second bit width of the second exponent field is greater than or equal to the first bit width of the second exponent field, perform a discard operation on the least significant bit of the to-be-retained coded value to obtain a second bit width of the second mantissa field and a second coded value of the second mantissa field.

12. The apparatus according to claim 8, wherein the bit width computing unit is further configured to:
determine an indication value based on the first coded value of the first exponent field, and determine, through table lookup, the first bit width of the prefix code field and the first coded value of the prefix code field that correspond to the indication value, wherein the indication value further indicates the first bit width of the second exponent field; and
determine, based on the first coded value of the first exponent field, the first coded value corresponding to the first bit width of the second exponent field.

13. The apparatus according to any one of claims 8 to 12, wherein the bit width computing unit is further configured to:
determine the first bit width of the second mantissa field based on a total bit width of the second floating-point data, the first bit width of the prefix code field, and the first bit width of the second exponent field.

14. The apparatus according to claim 8, wherein the bit width computing unit is further configured to:
when the first floating-point data exceeds an upper limit of a conversion range of the second floating-point data, determine the second floating-point data in a saturation mode or an infinity mode;
when the first floating-point data exceeds a lower limit of a conversion range of the second floating-point data, the second floating-point data is zero; or
when the first floating-point data is not a number, the second floating-point data is not a number.

15. A computer-readable storage medium, comprising computer instructions, wherein when the computer instructions are run on an electronic device, the electronic device is enabled to perform the method according to any one of claims 1 to 7.

16. A computer program product, wherein when the computer program product is run on a computer or a processor, the computer or the processor is enabled to perform the method according to any one of claims 1 to 7.
